# EUROPEAN PATENT APPLICATION

(11) **EP 4 205 880 A1**
(43) Date of publication of application: **05.07.2023**
(21) Application number: 21861124.2
(22) Date of filing: 30.07.2021
(51) Int. Cl.: B22F 1/00, B22F 7/08, B22F 9/00, H01B 1/22, H01L 21/52

(54) **JOINING COMPOSITION**

(30) Priority: 26.08.2020 JP 2020142824
(71) Applicant: Bando Chemical Industries, Ltd., Kobe-shi, Hyogo 650-0047 (JP)
(72) Inventor: WATANABE, Tomofumi, Kobe-shi, Hyogo 650-0047 (JP); EDAGAWA, Asako, Kobe-shi, Hyogo 650-0047 (JP); ARIKI, Nobutaka, Kobe-shi, Hyogo 650-0047 (JP)
(74) Representative: Müller-Boré & Partner Patentanwälte PartG mbB
(86) International application number: PCT/JP2021/028305
(87) International publication number: WO 2022/044696

(57) **Abstract**

The present invention provides a bonding composition which can be continuously printed by an automatic printing machine and has a high bonding strength. The bonding composition of the present invention contains silver particles and organic components, the organic components including two or more primary amines, an ether-based solvent, a solvent having two hydroxy groups, and a polymer dispersant, the two or more primary amines each having a carbon number of 4 to 12 and a boiling point of 300°C or lower. Preferably, the ether-based solvent is a glycol ester-based solvent or a glycol ether-based solvent and has a boiling point of 210°C or higher and 300°C or lower.

## Description

### TECHNICAL FIELD

The present invention relates to bonding compositions.

### BACKGROUND ART

Bonding materials have been used to mechanically, electrically, and/or thermally join a metal part to another. Examples of the bonding materials include solder, conductive adhesives, silver pastes, and anisotropic conductive films. These bonding materials are sometimes used not only for bonding metal parts to each other but also for bonding a metal part to a ceramic part, a resin part, or other parts. For example, bonding materials are sometimes used for bonding a light-emitting element such as a light emitting diode (LED), a semiconductor chip, or other parts to a substrate, and for further bonding such a substrate to a sinter dissipation component.

High-luminance lighting devices and light-emitting devices, each of which includes light-emitting elements such as LEDs, and semiconductor devices called power devices, which include semiconductor elements operable with a high efficiency at high temperatures, for example, tend to have high operation temperatures in use. Having a melting point lower than the operation temperatures of these devices, solder is unsuitable for bonding light-emitting elements such as LEDs, semiconductor chips, and other parts. Furthermore, lead-free bonding materials have been desired from the viewpoints of environmental protection and the regulations under the "Directive on the restriction of the use of certain hazardous substances in electrical and electronic equipment" (Restriction of Hazardous Substances Directive (RoHS)).

Bonding materials studied as new highly sinter - resistant lead-free bonding materials include those formed by sintering a bonding composition containing metal nanoparticles (see, for example, Patent Literature 1). For example, Patent Literature 1 states forming a porous metal layer by sintering through flash lamp annealing a coating film formed by applying a metal particle dispersion containing metal particles, a dispersant, and a solvent.

### CITATION LIST

### - Patent Literature

Patent Literature 1: JP 2016-110691 A

### SUMMARY OF INVENTION

### - Technical Problem

Conventional bonding compositions containing metal nanoparticles adhere in a large amount to the squeegee during printing while remaining in a small amount on the printing plate. The compositions therefore cannot be continuously printed by an automatic printing machine, leaving a room for improvement.

Also, devices with light-emitting elements such as LEDs, semiconductor chips, or other parts have been desired to have higher output power. Thus, the devices may be more highly integrated or the input power to the devices may be increased. As a result, the operation temperatures of these devices tend to be higher and the use environment for bonding materials tends to be more severe. Bonding of light-emitting elements such as LEDs, semiconductor chips, or other parts has thus required a high bonding strength for sufficient sinter resistance reliability.

The present invention was made in view of the current state of the art, and aims to provide a bonding composition which can be continuously printed by an automatic printing machine and has a high bonding strength.

### - Solution to Problem

The bonding composition of the present invention is a bonding composition containing: silver particles; and organic components, the organic components including two or more primary amines, an ether-based solvent, a solvent having two hydroxy groups, and a polymer dispersant, the two or more primary amines each having a carbon number of 4 to 12 and a boiling point of 300°C or lower.

Preferably, the ether-based solvent is a glycol ester-based solvent or a glycol ether-based solvent and has a boiling point of 210°C or higher and 300°C or lower.

Preferably, the solvent having two hydroxy groups is a diol-based solvent and has a boiling point of 210°C or higher and 300°C or lower.

Preferably, the two or more primary amines include three or more primary amines having a carbon number of 4 to 12 and a boiling point of 300°C or lower.

### - Advantageous Effects of Invention

The bonding composition of the present invention can be continuously printed by an automatic printing machine and has a high bonding strength.

### DESCRIPTION OF EMBODIMENTS

The bonding composition of the present invention contains: silver particles; and organic components, the organic components including two or more primary amines, an ether-based solvent, a solvent having two hydroxy groups, and a polymer dispersant, the two or more primary amines each having a carbon number of 4 to 12 and a boiling point of 300°C or lower. The "boiling point" herein is a value at an atmospheric pressure of 1 (under atmospheric pressure).

The bonding composition may be any bonding composition containing silver particles and organic components. Preferably, the bonding composition is in the paste form for easy application. The bonding composition may also contain particles of a metal(s) more noble in ionization series than hydrogen, such as gold, copper, platinum, or palladium, together with silver particles, for less or no occurrence of migration.

The silver particles preferably have an average particle size of 10 to 500 nm. Use of silver particles having an average particle size of 10 to 500 nm enables reduction in the level of volume shrinkage due to sintering, resulting in a homogeneous, dense bonding material. Use of silver particles having an average particle size smaller than 10 nm may allow sintering to proceed at low temperatures. Yet, the sintering of particles may cause an increase in the average particle size, followed by an increase in the level of volume shrinkage, so that the parts to be joined may not be able to follow the volume shrinkage. In such cases, voids and/or other defects occur in the bonding material to decrease the bonding strength and reliability of the bonding material. Meanwhile, use of silver particles having an average particle size larger than 500 nm may not allow sintering to proceed smoothly at low temperatures, and may leave large pores formed between particles after the sintering.

The average particle size of the silver particles can be determined by calculating the arithmetic mean of the particle sizes of about 100 to 200 particles from a photograph taken with a scanning electron microscope or a transmission electron microscope. Other methods for determining the average particle size include dynamic light scattering, small-angle X-ray scattering, and wide-angle X-ray diffraction. The "average particle size" herein refers to the arithmetic mean diameter.

The bonding composition may contain metal fine particles smaller in diameter than the silver particles. The metal fine particles may be dispersed in the bonding composition separately from the silver particles or may adhere to at least portions of the surfaces of some of the silver particles. The metal of the metal fine particles may be, for example, gold, copper, nickel, bismuth, tin, iron, or a platinum group element (ruthenium, rhodium, palladium, osmium, iridium, or platinum). These metals may be used alone or in combination of two or more.

The average particle size of the metal fine particles may be any size falling within the range that does not impair the effect of the present invention. Preferably, the average particle size is in the nanometer range where the metal fine particles have a decreased melting point, more preferably 20 to 300 nm. An average particle size of the metal fine particles of 20 nm or greater is practical as it results in no increase in cost of the production of the metal fine particles. An average particle size of 300 nm or smaller is also preferred as a bonding composition capable of forming a good bonding structure can be obtained.

The organic components include: (A) two or more primary amines; (B) an ether-based solvent; (C) a solvent having two hydroxy groups; and (D) a polymer dispersant.

### (A) Primary amine

The two or more primary amines may be used as dispersants that bind to the surfaces of the silver particles to form colloids, or as dispersion media (solvents) not adhering to the silver particles. When coated with the primary amines, the silver particles have higher dispersion stability and thus can be prevented from aggregation. If remaining in the bonding composition during sintering, an organic component inhibits the fusion of the silver particles. In this respect, the primary amines advantageously easily detach from the silver particles even in sintering in an atmosphere with a low oxygen concentration where organic substances are not combusted. In particular, a primary amine having a carbon number of 4 to 12 and a boiling point of 300°C or lower can be easily eliminated from the silver particles during sintering. The carbon number of a primary amine refers to the sum of the carbons in the main and side chains. Even when not adhering to the silver particles, the primary amines can promote fusion between the silver particles as they are easily volatilized (evaporated or decomposed) by sintering.

The bonding composition contains two or more primary amines, each of the two or more primary amines having a carbon number of 4 to 12 and a boiling point of 300°C or lower. Preferably, the bonding composition contains three or more primary amines, each of the three or more primary amines having a carbon number of 4 to 12 and a boiling point of 300°C or lower. The two or more primary amines preferably have different carbon numbers from each other and different boiling points from each other. With such properties, each amine can be eliminated and volatilized in phases during sintering, so that the sintering of silver particles can be controlled to form a dense sintered layer. The lower limit of the boiling point of each primary amine is preferably 100°C and the upper limit thereof is more preferably 250°C.

Each of the primary amines may be linear or branched, and may have a side chain(s). The primary amine may be any one of diamines, alkoxyamines, amino alcohols, alkylamines (linear alkylamines, which may have a side chain(s)), and cycloalkyl amines. Specific examples of the primary amine include 1,4-butanediamine, 1,5-pentanediamine, pentanolamine, aminoisobutanol, butylamine, pentylamine, hexylamine, heptylamine, octylamine, nonylamine, decylamine undecylamine, dodecylamine, cyclopentylamine, cyclohexylamine, 3-methoxypropylamine, diglycolamine, aniline, allylamine, 3-ethoxypropylamine, and 3-(2-ethylhexyloxy)propylamine.

The primary amine may contain functional groups other than amine functional groups, such as hydroxy groups, carboxyl groups, alkoxy groups, carbonyl groups, ester groups, and mercapto groups.

### (B) Ether-based solvent

The ether-based solvent itself has a low viscosity. Thus, the viscosity of the bonding composition (paste) can be easily decreased by blending an ether-based solvent into the bonding composition. For inhibiting drying during printing and for easy volatilization during bonding, the ether-based solvent preferably has a boiling point of 210°C to 300°C, more preferably 230°C to 290°C, still more preferably 240°C to 260°C.

Suitable as the ether-based solvent are glycol ester-based solvents and glycol ether-based solvents. These solvents are compatible with the primary amines having a carbon number of 4 to 12, which are used as dispersants to adhere to the silver particles in the bonding composition. These solvents thus can increase the dispersibility of the silver particles. The octanol/water partition coefficient of the ether-based solvents is preferably close to the octanol/water partition coefficient of the primary amines having a carbon number of 4 to 12, which act as dispersants to adhere to the silver particles. Specifically, the octanol/water partition coefficient of the ether-based solvents is preferably -1 to +6.

Specific examples of the ether-based solvents include hexyl ether, butyl carbitol, hexyl carbitol, dipropylene glycol-n-butyl ether, Terusolve THA-90, tripropylene glycol methyl ether, triethylene glycol monomethyl ether, diethylene glycol dibutyl ether, diethylene glycol monohexyl ether, triethylene glycol butyl methyl ether, dipropylene glycol monobutyl ether, tetraethylene glycol dimethyl ether, Terusolve TOE-100, butyl carbitol acetate, and triethylene glycol methyl ether acetate.

### (C) Solvent having two hydroxy groups

The solvent having two hydroxy groups itself has a high viscosity owing to the presence of two hydroxy groups, and thus can suppress and control the aggregation of the silver particles. Having two hydroxy groups, the solvent tends to repulsively interacts with the carbon chains of the primary amines which adhere to the silver particles, thus enabling control of the cohesive force of the bonding composition (paste). These actions of the solvent enable the paste to be roll-moved on the printing plate (i.e., cause rolling) by the moving squeegee during printing to easily fill in the openings in the metal mask, thus increasing the printability. In addition, since the solvent can control the cohesive force of the paste, the solvent can also suppress adhesion of the paste to the squeegee to leave the paste on the printing plate.

The solvent having two hydroxy groups is preferably a diol-based solvent. For inhibiting drying during printing, the solvent having two hydroxy groups preferably has a boiling point of 210°C to 300°C, more preferably 230°C to 290°C, still more preferably 240°C to 260°C.

Specific examples of the solvent having two hydroxy groups include 2-ethyl-1,3-hexanediol, ethylene glycol, diethylene glycol, propylene glycol, polyethylene glycol, polypropylene glycol, 1,3-butanediol, 1,4-butanediol, 1,5-pentanediol, 1,2-hexanediol, 1,2-octanediol, 3-methyl-1,5-pentanediol, 3-methyl-1,3-butanediol, and 2,4-diethyl-1,5-pentanediol.

### (D) Polymer dispersant

Containing a polymer dispersant, the bonding composition (paste) can be adjusted to have a viscosity and a cohesion which allow for printing even with reduced amounts of the solvents. The polymer dispersant is preferably acidic so as to disperse the silver particles under the acid-base interaction with the primary amines adhering to the silver particles. In addition, the polymer dispersant preferably exhibits no basicity.

The polymer dispersant can be any commercially available polymer dispersant. Examples of the commercially available polymer dispersant include SOLSPERSE 11200, SOLSPERSE 13940, SOLSPERSE 16000, SOLSPERSE 17000, SOLSPERSE 18000, SOLSPERSE 20000, SOLSPERSE 21000, SOLSPERSE 24000, SOLSPERSE 26000, SOLSPERSE 27000, SOLSPERSE 28000, SOLSPERSE 41000, SOLSPERSE 44000, SOLSPERSE 53095, and SOLSPERSE 54000 (all from Lubrizol Japan Limited); DISPERBYK 102, DISPERBYK 111, DISPERBYK 118, DISPERBYK 142, DISPERBYK 160, DISPERBYK 161, DISPERBYK 162, DISPERBYK 163, DISPERBYK 166, DISPERBYK 170, DISPERBYK 180, DISPERBYK 182, DISPERBYK 184, DISPERBYK 190, and DISPERBYK 2155 (all from BYK Japan KK); EFKA-46, EFKA-47, EFKA-48, and EFKA-49 (all from EFKA CHEMICALS B.V.); Polymer 100, Polymer 120, Polymer 150, Polymer 400, Polymer 401, Polymer 402, Polymer 403, Polymer 450, Polymer 451, Polymer 452, and Polymer 453 (all from EFKA CHEMICALS B.V.); AJISPER PB711, AJISPER PA111, AJISPER PB811, and AJISPER PW911 (all from Ajinomoto Fine-Techno Co., Inc.); and FLOWLEN DOPA-15B, FLOWLEN DOPA-22, FLOWLEN DOPA-17, FLOWLEN TG-730W, FLOWLEN G-700, and FLOWLEN TG-720W (all from Kyoeisha Chemical Co., Ltd.). From the viewpoint of low temperature sintering and dispersion stability, SOLSPERSE 11200, SOLSPERSE 13940, SOLSPERSE 16000, SOLSPERSE 17000, SOLSPERSE 18000, SOLSPERSE 28000, SOLSPERSE 54000, DISPERBYK 142, or DISPERBYK 2155 is preferably used.

As described above, the bonding composition (paste) uses a solvent which is a combination of a solvent having two hydroxy groups and a polymer dispersant to not or less adhere to the squeegee and to be continuously printable. Such a bonding composition still causes blurring around the printed paste, is poorly releasable from the plate, and generates voids during bonding. The bonding composition therefore further contains an ether-based solvent having a relatively low viscosity to further exhibit cohesion. The paste thus easily breaks when running down and stretching, thus solving the blurring and the poor plate release from the plate. In addition, since the solvent as a combination of a solvent having two hydroxy groups, a polymer dispersant, and an ether-based solvent has good compatibility with the amine dispersants, the solvent can control aggregation and behavior during sintering of the silver particles from the solvent volatilization to dispersant elimination during sintering, thus achieving a void-free bonding state (in other words, a bonding state with low porosity). As described above, since the bonding composition can achieve a low porosity, the bonding composition can achieve a high bonding strength even when used for, for example, non-pressure bonding with a solid copper plate in a nitrogen atmosphere.

In order to achieve the effects described above, the amount of the silver particles in the bonding composition is preferably 90% by mass or more and 96% by mass or less, and the amount of the organic components in the bonding composition is preferably 4% by mass or more and 10% by mass or less.

The amount of the primary amines relative to all the organic components is preferably 1% by mass or more and 50% by mass or less. The amount of the ether-based solvent is preferably 5% by mass or more and 90% by mass or less. The amount of the solvent having two hydroxy groups relative to all the organic components is preferably 5% by mass or more and 90% by mass or less. The amount of the polymer dispersant relative to all the organic components is preferably 0.1% by mass or more and 5% by mass or less.

The organic components may include an unsaturated hydrocarbon. Such organic components increase the dispersibility of the silver particles and, even when contained in a small amount in the whole bonding composition, can make the bonding composition into a paste.

Examples of the unsaturated hydrocarbon include acetylene, benzene, 1-hexene, 1-octene, 4-vinylcyclohexene, terpene alcohols, allyl alcohol, oleyl alcohol, 2-palmitoleic acid, petroselinic acid, oleic acid, elaidic acid, Tianshic acid, ricinoleic acid, linoleic acid, linoelaidic acid, linolenic acid, arachidonic acid, acrylic acid, methacrylic acid, gallic acid, and salicylic acid.

In particular, an unsaturated hydrocarbon having a hydroxy group is preferred. Examples of the unsaturated hydrocarbon having a hydroxy group include terpene alcohols, allyl alcohol, oleyl alcohol, Tianshic acid, ricinoleic acid, gallic acid, and salicylic acid. Preferably, an unsaturated fatty acid having a hydroxy group is used. Examples thereof include Tianshic acid, ricinoleic acid, gallic acid, and salicylic acid.

The unsaturated hydrocarbon is preferably ricinoleic acid. Ricinoleic acid has carboxy and hydroxy groups and adsorbs onto the surfaces of the silver particles to uniformly disperse the silver particles while promoting fusion of the silver particles and bonding of the silver particles to the parts to be joined.

The bonding composition may contain optional components such as binders, thickeners, surfactants, and surface tension adjusters in addition to the above-described components to adjust the dispersibility of the silver particles as well as the viscosity, adhesion, drying, and applicability (printability) of the composition which are appropriate for the purpose of use, as long as the effects of the present invention are not impaired. Such optional components are not limited.

The bonding composition preferably has a solids concentration of 93% by mass to 96% by mass. The solids concentration is a concentration of solids remaining in the composition when the temperature of the composition is raised to 550°C in air. If the solids concentration is below 93% by mass, the bonding composition would contain a relatively large amount of the organic components, which would increase the amount of the organic components that volatilize during bonding, likely generating voids and/or pores. If the solids concentration exceeds 96% by mass, the fluidity as a bonding composition (paste) may deteriorate to lead to poor printability. The higher the solids concentration, the denser the bonding layer obtained by sintering the bonding composition, and the higher the bonding strength.

Unlike conventional bonding compositions which achieve the bonding strength after sintering owing to the thermal curing of epoxy or other resins, the bonding composition of the present invention achieves a sufficient bonding strength through sintering of the silver particles as described above. Thus, even when the residual organic material after the bonding deteriorates, decomposes, or disappears in a use environment at temperatures higher than the bonding temperature, there is no concern about decrease in the bonding strength. The bonding composition therefore has excellent sinter resistance.

### EXAMPLES

The present invention is described in more detail below based on examples. The present invention is not limited to these examples.

### <Example 1>

To 3.0 g of 3-methoxypropylamine (carbon number: 4, boiling point: 116°C) was added 3.0 g of silver oxalate with thorough stirring with a magnetic stirrer for thickening. The resulting viscous substance was placed in a thermostatic bath at 100°C and allowed to react for about 15 minutes. For replacement of the dispersion medium of the suspension, first, 10 ml of methanol was added to the resulting suspension, followed by stirring. The mixture was then centrifuged to separate silver particles through precipitation. The supernatant was discarded. This process from the addition to the discarding was repeated twice. Thus, silver fine particles A were obtained.

Next, to 6.0 g of diglycolamine (carbon number: 4, boiling point: 220°C) and 0.5 g of dodecylamine (carbon number: 12, boiling point: 249°C) was added 3.0 g of silver oxalate with thorough stirring with a magnetic stirrer for thickening. The resulting viscous substance was placed in a thermostatic bath at 100°C and allowed to react for about 15 minutes. For replacement of the dispersion medium of the suspension, first, 10 ml of methanol was added to the resulting suspension, followed by stirring. The mixture was then centrifuged to separate silver particles through precipitation. The supernatant was discarded. This process from the addition to the discarding was repeated twice. Thus, silver fine particles B were obtained.

To 2 g of the silver fine particles A and 2 g of the silver fine particles B were added 0.1 g of 2-ethyl-1,3-hexanediol (boiling point: 243°C), 0.1 g of butyl carbitol acetate (glycol ester-based solvent, boiling point: 247°C), 0.02 g of octylamine (carbon number: 8, boiling point: 175°C to 177°C), 0.01 g of SOLSPERSE^{®} 16000 (available from Lubrizol Japan Limited), and 0.01 g of ricinoleic acid, followed by mixing with stirring. Thereby, a bonding composition was obtained.

### <Example 2>

A bonding composition was prepared as in Example 1, except that SOLSPERSE 16000 was replaced by SOLSPERSE 41000 (available from Lubrizol Japan Limited).

### <Example 3>

A bonding composition was prepared as in Example 1, except that SOLSPERSE 16000 was replaced by SOLSPERSE 21000 (available from Lubrizol Japan Limited).

### <Example 4>

To 15.0 g of 3-methoxypropylamine and 1.0 g of 3-ethoxypropylamine (carbon number: 5, boiling point: 130°C) was added 3.0 g of silver oxalate with thorough stirring with a magnetic stirrer for thickening. The resulting viscous substance was placed in a thermostatic bath at 100°C and allowed to react for about 15 minutes. For replacement of the dispersion medium of the suspension, first, 10 ml of methanol was added to the resulting suspension, followed by stirring. The mixture was then centrifuged to separate silver particles through precipitation. The supernatant was discarded. This process from the addition to the discarding was repeated twice. Thus, silver fine particles C were obtained.

To 4 g of the silver fine particles C were added 0.1 g of 2-ethyl-1,3-hexanediol, 0.1 g of hexyl carbitol (glycol ether-based solvent, boiling point: 258°C), 0.02 g of octylamine, 0.01 g of SOLSPERSE 16000, and 0.01 g ricinoleic acid, followed by mixing with stirring. Thereby, a bonding composition was obtained.

### <Example 5>

To 15.0 g of 3-methoxypropylamine and 1.5 g of 3-ethoxypropylamine was added 3.0 g of silver oxalate with thorough stirring with a magnetic stirrer for thickening. The resulting viscous substance was placed in a thermostatic bath at 100°C and allowed to react for about 15 minutes. For replacement of the dispersion medium of the suspension, first, 10 ml of methanol was added to the resulting suspension, followed by stirring. The mixture was then centrifuged to separate silver particles through precipitation. The supernatant was discarded. This process from the addition to the discarding was repeated twice. Thus, silver fine particles D were obtained.

To 4 g of the silver fine particles D were added 0.1 g of 2-ethyl-1,3-hexanediol, 0.1 g of butyl carbitol acetate, 0.02 g of octylamine, 0.01 g of SOLSPERSE 21000, and 0.01 g of ricinoleic acid, followed by mixing with stirring. Thereby, a bonding composition was obtained.

### <Example 6>

A bonding composition was prepared as in Example 4, except that octylamine was not added.

### <Example 7>

To 4 g of the silver fine particles D were added 0.1 g of 2-ethyl-1,3-hexanediol, 0.1 g of butyl carbitol acetate, 0.02 g of 3-(2-(ethylhexyloxy)propylamine (carbon number: 11, boiling point: 235°C), 0.02 g of octylamine, 0.01 g SOLSPERSE 21000, and 0.01 g ricinoleic acid, followed by mixing with stirring. Thereby, a bonding composition was obtained.

### <Example 8>

To 15.0 g of 3-methoxypropylamine and 1.5 g of 3-ethoxypropylamine was added 3.0 g of silver oxalate with thorough stirring with a magnetic stirrer for thickening. The resulting viscous substance was placed in a thermostatic bath at 100°C and allowed to react for about 15 minutes. For replacement of the dispersion medium of the suspension, first, 2 g of octylamine and 10 ml of methanol were added to the resulting suspension, followed by stirring for one hour. The mixture was then centrifuged to separate silver particles through precipitation. The supernatant was discarded. To the separated silver particles was further added 10 ml of methanol, followed by stirring. The mixture was then centrifuged to separate the silver particles through precipitation. The supernatant was discarded. Thus, silver fine particles E with octylamine adhering thereto were obtained.

To 4 g of the silver fine particles E were added 0.1 g of 2-ethyl-1,3-hexanediol, 0.1 g of butyl carbitol acetate, 0.02 g of 3-(2-(ethylhexyloxy)propylamine, 0.01 g of SOLSPERSE 21000, and 0.01 g ricinoleic acid, followed by mixing with stirring. Thereby, a bonding composition was prepared.

### <Comparative Example 1>

To 3.0 g of 3-methoxypropylamine was added 3.0 g of silver oxalate with thorough stirring with a magnetic stirrer for thickening. The resulting viscous substance was placed in a thermostatic bath at 100°C and allowed to react for about 15 minutes. To the substance was added 20 g of dodecylamine, and the mixture was allowed to react at the same temperature for 15 minutes. For replacement of the dispersion medium of the suspension, first, 10 ml of methanol was added to the resulting suspension, followed by stirring. The mixture was then centrifuged to separate silver particles through precipitation. The supernatant was discarded. This process from the addition to the discarding was repeated twice. Thus, different silver fine particles E were obtained.

Next, to 6.0 g of diglycolamine was added 3.0 g of silver oxalate with thorough stirring with a magnetic stirrer for thickening. The resulting viscous substance was placed in a thermostatic bath at 100°C and allowed to react for about 15 minutes. To the substance was added 20 g of dodecylamine, and the mixture was allowed to react at the same temperature for 15 minutes. For replacement of the dispersion medium of the suspension, first, 10 ml of methanol was added to the resulting suspension, followed by stirring. The mixture was then centrifuged to separate silver particles through precipitation. The supernatant was discarded. This process from the addition to the discarding was repeated twice. Thus, silver fine particles F were obtained.

To 1 g of the different silver fine particles E and 1 g of the silver fine particles F were added 0.1 g of 2-ethyl-1,3-hexanediol, 0.1 g of butyl carbitol acetate, and 0.01 g of ricinoleic acid, followed by mixing with stirring. Thereby, a bonding composition was obtained.

### <Comparative Example 2

A bonding composition was prepared as in Example 1, except that SOLSPERSE 16000 was not added.

### <Comparative Example 3>

A bonding composition was prepared as in Example 2, except that butyl carbitol acetate was not added and the amount of 2-ethyl-1,3-hexanediol added was changed to 0.2 g.

### <Comparative Example 4>

A bonding composition was prepared as in Example 4, except that 2-ethyl-1,3-hexanediol was not added and the amount of butyl carbitol acetate added was changed to 0.2 g.

### <Comparative Example 5>

To 3.0 g of 3-methoxypropylamine was added 3.0 g of silver oxalate with thorough stirring with a magnetic stirrer for thickening. The resulting viscous substance was placed in a thermostatic bath at 100°C and allowed to react for about 15 minutes. To the substance was added 20 g of octylamine, and the mixture was allowed to react at the same temperature for 15 minutes. For replacement of the dispersion medium of the suspension, first, 10 ml of methanol was added to the resulting suspension, followed by stirring. The mixture was then centrifuged to separate silver particles through precipitation. The supernatant was discarded. This process from the addition to the discarding was repeated twice. Thus, silver fine particles G were obtained.

Next, to 6.0 g of diglycolamine was added 3.0 g of silver oxalate with thorough stirring with a magnetic stirrer for thickening. The resulting viscous substance was placed in a thermostatic bath at 100°C and allowed to react for about 15 minutes. To the substance was added 20 g of octylamine, and the mixture was allowed to react at the same temperature for 15 minutes. For replacement of the dispersion medium of the suspension, first, 10 ml of methanol was added to the resulting suspension, followed by stirring. The mixture was then centrifuged to separate silver particles through precipitation. The supernatant was discarded. This process from the addition to the discarding was repeated twice. Thus, silver fine particles H were obtained.

To 1 g of the silver fine particles G and 1 g of the silver fine particles H were added 0.05 g of hexyl carbitol, 0.05 g of butyl carbitol acetate, and 0.005 g of ricinoleic acid, followed by mixing with stirring. Thereby, a bonding composition was obtained.

### (Evaluation test)

The following evaluation tests on the bonding compositions prepared in the examples and comparative examples were performed. The following Table 1 and Table 2 show the results.

### (1) Measurement of bonding strength

The obtained bonding compositions each were applied through a metal mask to a 6-mm-square portion of a solid oxygen-free copper plate (20-mm square) with the oxide film removed. A gold-plated Si chip (base area: 5 mm × 5 mm) was placed on the portion and pressed onto the portion at 0.1 kgf (0.98 N) to obtain a laminate.

The resulting laminate was then placed in a reflow ove n (available from Shinapex Co., Ltd.), into which nitrogen w as then flown. When the oxygen concentration reached 300 pp m, the laminate was sintered by raising the temperature in r eflow oven from room temperature to 70°C, maintaining the te mperature at 70°C for 30 minutes, raising the temperature to a maximum temperature of 250°C at a temperature increase ra te of 3.3°C/min, and maintaining the temperature at 250°C fo r 30 minutes. The sintering was pressureless sintering with no pressure applied to the laminate. After the sintering, the laminate was naturally cooled and then taken out of the oven. Nitrogen was kept flowing during cooling. The bondin g strength of the laminate was then measured at room tempera ture with a bonding tester (available from RHESCA Co., LTD.) using a 100-kgf load cell. Since the 5-mm-square chip was s ubjected to the measurement with the 100-kgf load cell, the upper limit of the measurement of the bonding strength was a bout 40 MPa.

### (2) Void measurement

The laminate prepared in (1) above before the bonding strength measurement was analyzed with an ultrasonic flaw detector (available from Krautkramer Japan Co., Ltd.). The laminate was analyzed from the copper plate side at a frequency of 25 MHz. A laminate with many voids was evaluated as "Poor", a laminate with few voids was evaluated as "Fair", and a laminate with no or almost no voids was evaluated as "good".

### (3) Evaluation of automatic printability

A metal mask with a plate thickness of 70 um and a 6-mm-square opening in the center of the plate was set in an auto printing machine (available from Seria Corporation). An amount of 10 g of the obtained paste of the target bonding composition was placed on the metal mask. A 0.2-mm-thick metal squeegee was moved at 50 mm/s to move the paste to the opening in the center of the plate to print the paste onto a solid oxygen-free copper plate (20-mm square). Then, the metal squeegee was reciprocated 199 times without adding the paste so as to reciprocate the paste between the position at which the paste was first placed and the opening. When the paste reached the opening for the 200th time, the paste was printed on the copper plate again. A paste forming the coating films of the same shape as the opening both in the first printing and the 200th movement printing was evaluated as "Good", a paste forming a coating film of an incomplete shape in the 200th movement printing was evaluated as "Fair", and a paste forming a coating film of an incomplete shape in the first printing was evaluated as "Poor".

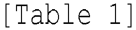

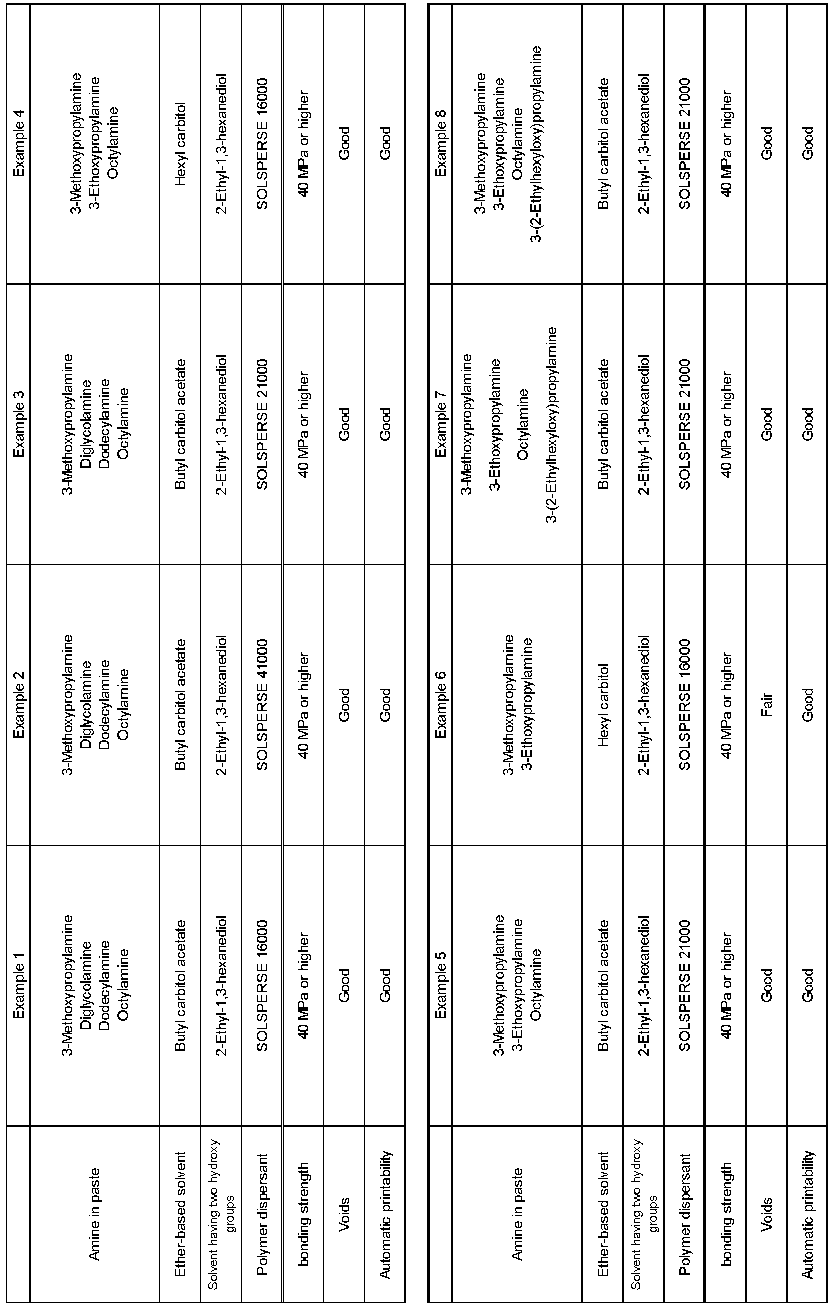

**[Table 2]**

| | Comparative Example 1 | Comparative Example 2 | Comparative Example 3 | Comparative Example 4 | Comparative Example 5 |
|---|---|---|---|---|---|
| Amine in paste | 3-Methoxypropylamine | 3-Methoxypropylamine | 3-Methoxypropylamine | 3-Methoxypropylamine | 3-Methoxypropylamine |
| | | Diglycolamine | Diglycolamine | | |
| | Diglycolamine | Dodecylamine | Dodecylamine | 3-Ethoxypropylamine | Diglycolamine |
| | Dodecylamine | Octylamine | Octylamine | Octylamine | Octylamine |
| Ether-based solvent | Butyl carbitol acetate | Butyl carbitol acetate | None | Butyl carbitol acetate | Butyl carbitol acetate Hexyl carbitol |
| Solvent having two hydroxy groups | 2-Ethyl-1,3-hexanediol | 2-Ethyl-1,3-hexanediol | 2-Ethyl-1,3-hexanediol | None | None |
| Polymer dispersant | None | None | SOLSPERSE 41000 | SOLSPERSE 16000 | None |
| bonding strength | 20 MPa | 38 MPa | 30 MPa | 35 MPa | 40 MPa |
| Voids | Poor | Fair | Poor | Fair | Fair |
| Automatic printability | Poor | Fair | Fair | Poor | Poor |

## Claims

1. A bonding composition comprising:
silver particles; and
organic components,
the organic components including two or more primary amines, an ether-based solvent, a solvent having two hydroxy groups, and a polymer dispersant,
the two or more primary amines each having a carbon number of 4 to 12 and a boiling point of 300°C or lower.

2. The bonding composition according to claim 1,
wherein the ether-based solvent is a glycol ester-based solvent or a glycol ether-based solvent and has a boiling point of 210°C or higher and 300°C or lower.

3. The bonding composition according to claim 1 or 2,
wherein the solvent having two hydroxy groups is a diol-based solvent and has a boiling point of 210°C or higher and 300°C or lower.

4. The bonding composition according to any one of claims 1 to 3,
wherein the two or more primary amines include three or more primary amines having a carbon number of 4 to 12 and a boiling point of 300°C or lower.
